# EUROPÄISCHE PATENTSCHRIFT

(11) **EP 3 864 943 B1**
(45) Veröffentlichungstag und Bekanntmachung des Hinweises auf die Patenterteilung: **13.09.2023**
(21) Anmeldenummer: 19801717.0
(22) Anmeldetag: 30.10.2019
(51) Int. Cl.: H05K 7/20, H02G 5/10

(54) **VORRICHTUNG ZUR KÜHLUNG EINER STROMSCHIENE**
DEVICE FOR COOLING A BUSBAR
DISPOSITIF DE REFROIDISSEMENT D'UN RAIL CONDUCTEUR

(30) Priorität: 27.11.2018 EP 18208453
(43) Veröffentlichungstag der Anmeldung: 18.08.2021
(73) Patentinhaber: Siemens Aktiengesellschaft, 80333 München (DE)
(72) Erfinder: HOFFMANN, Ingolf, 91074 Herzogenaurach (DE)
(74) Vertreter: Siemens Patent Attorneys
(86) Internationale Anmeldenummer: PCT/EP2019/079586
(87) Internationale Veröffentlichungsnummer: WO 2020/108905

(56) Entgegenhaltungen:
- EP-A1- 1 995 840
- EP-A1- 2 356 894
- EP-B1- 2 356 894
- WO-A1-2017/103844
- DE-A1-102007 003 875
- US-A1- 2012 113 569
- US-A1- 2015 124 381

## Beschreibung

Die Erfindung betrifft eine Vorrichtung zur Kühlung einer Stromschiene.

Stromschienen von, zu und in leistungselektronischen Geräten, in Schaltschränken und Verteilungsanlagen der Nieder- und Mittelspannung weisen eine Eigenerwärmung auf, die je nach Dimensionierung der Stromschiene und der vorhandenen Stromdichte in der Stromschiene zu einer Temperaturerhöhung führt. So liegt beispielsweise die Grenze für Stromschienen aus Kupfer bei ca. 2,2 A/mm² bei Stromschienen aus Aluminium bei ca. 1,5 A/mm². Sind diese Stromschienen beispielsweise mit Halbleitermodulen eines Umrichters eines Antriebs elektrisch kontaktiert, so kann sich ein Wärmefluss von der Stromschiene in das Halbleitermodul einstellen. Dieser gegebenenfalls zusätzliche Wärmeeintrag in das Halbleitermodul kann dessen Lebensdauer erheblich reduzieren und demnach zu Ausfällen des Halbleitermoduls und damit der Stromrichter und deren Antrieb führen.

Des Weiteren muss die Verlustwärme der Stromschienen zusätzlich zu der in den leistungselektronischen Geräten entstehenden Wärme beispielsweise aus Schaltschränken abgeführt werden. Diese leistungselektronischen Geräte sind beispielsweise Halbleitermodule, Kondensatoren oder Drosseln.

Bei flüssigkeitsgekühlten leistungselektronischen Geräten, die von ihrer Bauart her in Schaltschränken hoher Schutzart vorgesehen sind, ist dabei die Wärme nur unter vergleichsweise hohem Aufwand abzuführen.

Die Verlustwärme der Stromschienen kann auch passiv durch Oberflächenvergrößerung, beispielsweise durch Kühlbleche mittels Eigenkonvektion abgeführt werden.

Des Weiteren kann die Verlustwärme der Stromschienen auch aktiv durch Oberflächenvergrößerung, mittels Kühlblechen und/oder beschleunigter Konvektion durch zusätzliche Lüfter abgeführt werden.

Nachteil bei den prinzipiell dargestellten Lösungen ist, dass die Menge der Verlustwärme der Stromschienen zusätzlich zu der in den leistungselektronischen Geräten anfallenden Wärme u.a. aus der Luft abgeführt werden muss. Dies führt insbesondere bei flüssigkeitsgekühlten leistungselektronischen Geräten zu Nachteilen, da die Wärmemenge der Stromschienen über Luftkonvektion abgeführt werden muss, um die leistungselektronischen Geräte nicht zusätzlich aufzuheizen.

Aus der DE 10 2007 003 875 A1 ist eine Vorrichtung zur Kühlung einer Stromschiene mit einem Wärmeaufnahmeelement, einem Wärmetransportsystem und einem Wärmeabgabeelement bekannt, wobei das Wärmeaufnahmeelement formschlüssig an einer Stromschiene anliegt und das Wärmeabgabeelement formschlüssig an einer Wärmesenke anliegt, wobei das Wärmeaufnahmeelement und das Wärmeabgabeelement parallel zueinander ausgerichtet sind.

Aus der EP 2 356 894 A1 ist ein Stromrichtermodul zur Kühlung einer Stromschiene bekannt, bei der ein Flüssigkeitskühlkörper durch Druckelemente an eine Stromschiene gedrückt wird. Weiterhin ist der Flüssigkeitskühlkörper über Schläuche mit einem Wärmeabgabeelement verbunden.

Aus der US 2012/113569 A1 sind Stromschienen zwischen zwei Wärmesenken bekannt, wobei die Wärmesenken die Wärme an ihren Enden an ein Gehäuse abgeben.

Aus der US 2015/124381 A1 ist ein Wärmeaufnahmeelement und ein Wärmeabgabeelement bekannt, die über ein Wärmetransportsystem verbunden sind.

Ausgehend davon liegt der Erfindung die Aufgabe zugrunde eine Vorrichtung zur Kühlung einer Stromschiene bereitzustellen, die die oben genannten Nachteile vermeidet.

Die Lösung der gestellten Aufgabe gelingt durch eine Vorrichtung zur Kühlung einer Stromschiene gemäß den Merkmalen nach Anspruch 1.

Die Lösung der gestellten Aufgabe gelingt auch durch die Verwendung dieser Vorrichtung zur Kühlung zumindest einer Stromschiene in kompakten elektrischen Schaltanlagen mit Stromschienenanordnungen, insbesondere Schaltschränken von Umrichtern, Niederspannungsschaltanlagen und Mittelspannungsschaltanlagen.

Erfindungsgemäß wird nunmehr ein Wärmetransportsystem bereitgestellt, das ein Wärmeaufnahmeelement, ein Wärmetransportsystem und ein Wärmeabgabeelement aufweist, um somit die Wärmequelle, also die Stromschiene mit einer Wärmesenke beispielsweise einem Wärmetauscher oder einer anderen kühleren Umgebung wärmetechnisch leitend zu verbinden.

Wärmeaufnahmeelement als auch Wärmeabgabeelement sind dabei aufgrund der vergleichsweise guten Wärmeleitfähigkeit in Kupfer ausgeführt. Ebenso kann das Wärmetransportsystem als Kupfer aus Vollmaterial oder als Wärmerohr ausgeführt sein.

Die Vorrichtung zur Kühlung der Stromschiene kann in ihrer Anzahl skalierbar ausgeführt werden und somit an die erforderliche Wärmetransportleistung modular angepasst werden.

Als wärmetechnisch leitende Verbindungsverfahren zwischen dem Wärmeaufnahmeelement und Wärmeabgabeelement und Wärmetransportsystem eignen sich bei Kupfer in Vollmaterial Schweiß- und Lötverbindungen.

Um einen zusätzlichen Anpressdruck der Wärmeaufnahmeelemente und/oder Wärmeabgabeelemente an ihre zusätzlichen Wärmesenken und Wärmequellen zu erhalten, werden an und/oder zwischen den Wärmeaufnahmeelementen und Wärmeabgabeelementen Anpresselemente vorgesehen, die als Druckfedern bzw. Tellerfedern ausgeführt sind.

Bei einer gegenseitigen Abstützung ist dadurch auch gewährleistet, dass die Wärmeaufnahmeelemente und die Wärmeabgabeelemente stets parallel ausgerichtet sind.

Da die Stromschiene im Normalbetrieb potentialbehaftet ist, das Wärmeaufnahmeelement in der Regel jedoch auf Massepotential ist, ist somit eine elektrische Isolation zwischen Wärmeaufnahmeelement und der Stromschiene erforderlich. Dazu wird das Wärmeaufnahmeelement mit einer Isolationsschicht umhüllt. Diese kann als Keramikwärmeleitfolie oder Phase-change Folie ausgeführt sein, was zur elektrischen Isolation und einem gleichzeitigen Wärmefluss beiträgt.

Damit auch bei der Wärmeabgabe neben einer großflächigen Kontaktierung auch ein dementsprechender Wärmefluss gewährleistet ist, kann das Wärmeabgabeelement mit der Wärmesenke ebenso mit einer Wärmeleitfolie einer Phase-change Folie oder einer Wärmeleitpaste versehen werden. Vorteilhafterweise ist durch die nunmehr großflächigen Kontaktanliegeelemente, wie Wärmeaufnahmeelement, Wärmeabgabeelement und ausreichender Wärmetransport die Stromschiene vergleichsweise gut gekühlt.

Ein Wärmeeintrag in die leistungselektronischen Geräte wird somit vermieden.

Die Wärmeaufnahmeelemente und Wärmeabgabeelemente sind vorzugsweise eben ausgeführt, um sich möglichst der Oberfläche der - in der Regel ebenen - Stromschiene anzupassen. Bei anderen Querschnittsformen der Stromschiene, also quadratisch, trapezförmig, oval etc. sind die Wärmeaufnahmeelemente und Wärmeabgabeelemente dementsprechend angepasst auszuführen. Geringere Anpassungen an die Oberflächenstrukturen von Stromschiene und/oder Wärmeaufnahmeelement bzw. Wärmeabgabeelement erfolgt auch über die Wärmeleitfolien und/oder Wärmeleitpasten.

Ebenso lassen erfindungsgemäß diese Wärmeaufnahmeelemente und Wärmeabgabeelemente auch eine Kompensation bei wärmebedingten und/oder mechanischen Ausdehnungen der Stromschiene zu, ohne den wärmeleitenden Kontakt zu verlieren. Dies wird u.a. durch die Anpresselemente gewährleistet.

Die Vorrichtung ermöglicht nunmehr eine Entwärmung der Stromschienen, ohne wesentliche Wärmeabgabe an die Umgebung, insbesondere in einem Schaltschrank. Des Weiteren ist durch die Variation der Anzahl und/oder Art der Wärmeaufnahmeelemente, Wärmeabgabeelemente und auch Wärmetransportelemente die Kühlleistung skalierbar. Die Wärmeabgabeelemente sind vorzugsweise außerhalb eines Schaltschrankes angeordnet.

Des Weiteren ist diese Vorrichtung auch besonders geeignet für den Einsatz in flüssigkeitsgekühlten leistungselektronischen Geräten, womit die Montage dieser Vorrichtung in Schaltschränken hoher Schutzart ohne Zusatzaufwand möglich ist.

Die Erfindung sowie weitere vorteilhafte Ausgestaltungen der Erfindung werden anhand prinzipiell dargestellter Ausführungsbeispiele näher erläutert, darin zeigen:
- FIG 1: das Prinzip von Wärmequelle Wärmesenke,
- FIG 2, 3: unterschiedliche Ansichten der Wärmeabgabe- bzw. Aufnahmeelemente,
- FIG 4, 5: diese Elemente mit Druckfedern,
- FIG 6, 7: die Vorrichtung an Stromschiene und Wärmesenke,
- FIG 8, 9: die Vorrichtung zur Kühlung innerhalb eines leistungselektronischen Gerätes.

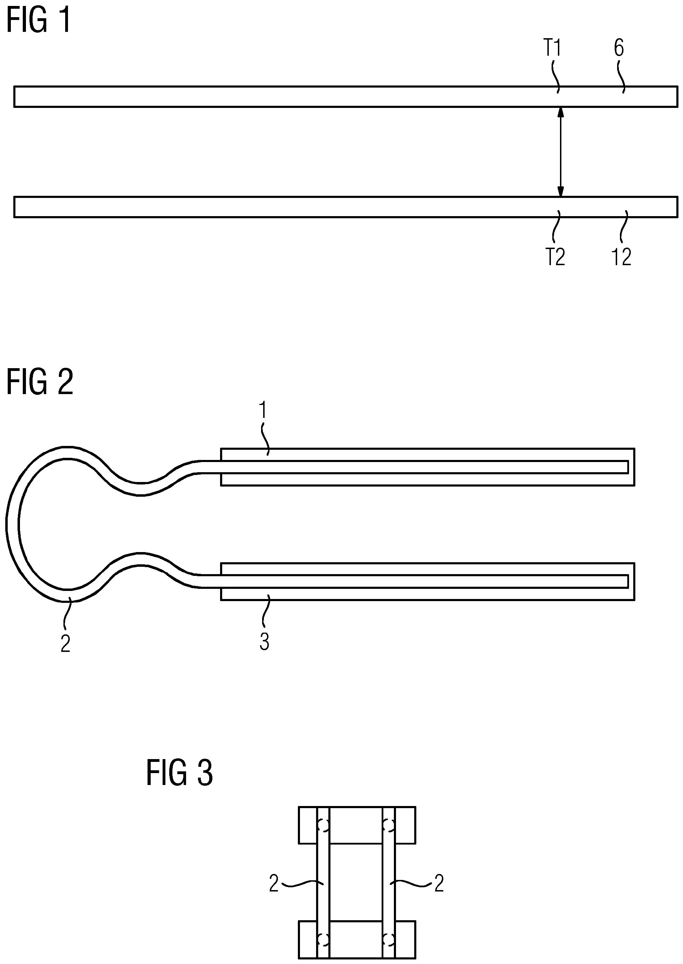

FIG 1 zeigt in prinzipieller Darstellung eine Wärmequelle mit einer Temperatur T1 und einer Wärmesenke 12 mit einer Temperatur T2. T1 ist dabei größer als T2. Dabei soll die Wärme aus der Wärmequelle zur Wärmesenke 12 geführt werden.

Dies geschieht, wie in FIG 2 und FIG 3 in unterschiedlichen Perspektiven dargestellt, durch ein Wärmeaufnahmeelement 1 das über ein Wärmetransportsystem 2 mit einem Wärmeabgabeelement 3 thermisch leitend verbunden ist. An einer Stromschiene 6 sind dabei skalierbar mehrere Wärmeaufnahmeelemente 1, Wärmeabgabeelement3 und auch mehrere Wärmetransportsysteme 2 anordenbar.

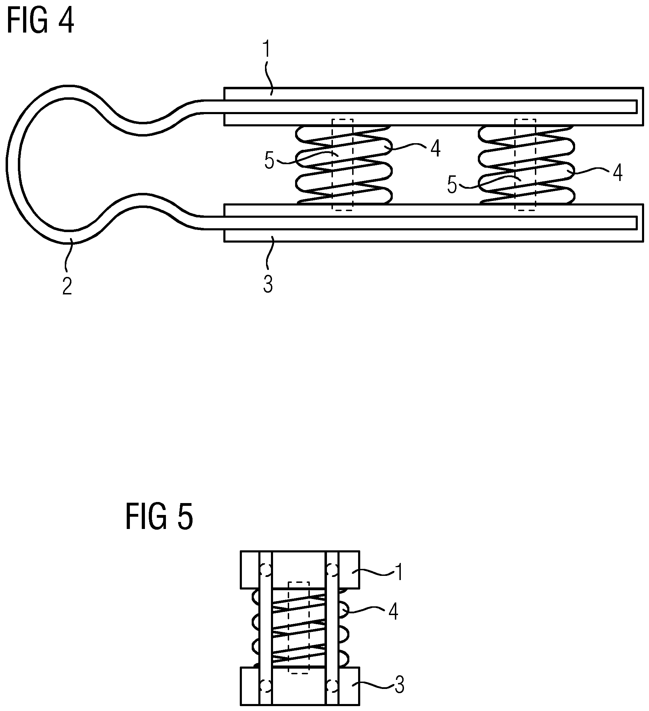

FIG 4 zeigt die Anordnung gemäß FIG 2 und FIG 3 mit einer Druckfeder 4 zwischen Wärmeaufnahmeelement 1 und Wärmeabgabeelement 3, um einen zusätzlichen Anpressdruck an gewisse Wärmequellen und Wärmesenken zu erhalten, um jeweils den Wärmeübergang zu verbessern. Die Druckfedern 4 werden dabei durch einen Führungsstift 5 geführt. Diese Anordnung gestattet eine Kompensation bei wärmebedingten und/oder mechanischen Ausdehnungen der Stromschiene 6, ohne den wärmeleitenden Kontakt zu beeinträchtigen.

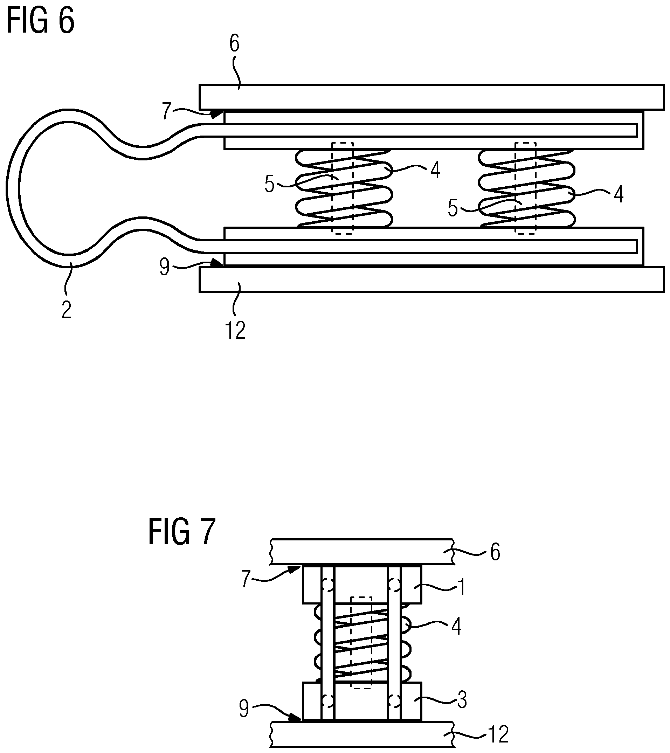

FIG 6, FIG 7 zeigen die Anordnung mit Druckfedern 4 nunmehr im Einsatz an einer Stromschiene 6, die mit einer Isolationsschicht 7 vom Wärmeaufnahmeelement 1 beabstandet ist. Zwischen Stromschiene 6 und Wärmeaufnahmeelement 1 und/oder zwischen Wärmeabgabeelement 3 und Wärmesenke 12 ist beispielsweise eine Wärmeleitpaste 9 vorgesehen, um die Wärme von der Stromschiene 6 über die Isolationsschicht 7 an das Wärmeaufnahmeelement 1 bzw. vom Wärmeabgabeelements 3 an die Wärmesenke 12 abzugeben. Die Wärmesenke 12 ist beispielsweise als Wärmetauscher ausgeführt, der außerhalb eines Schaltschrankes angeordnet ist.

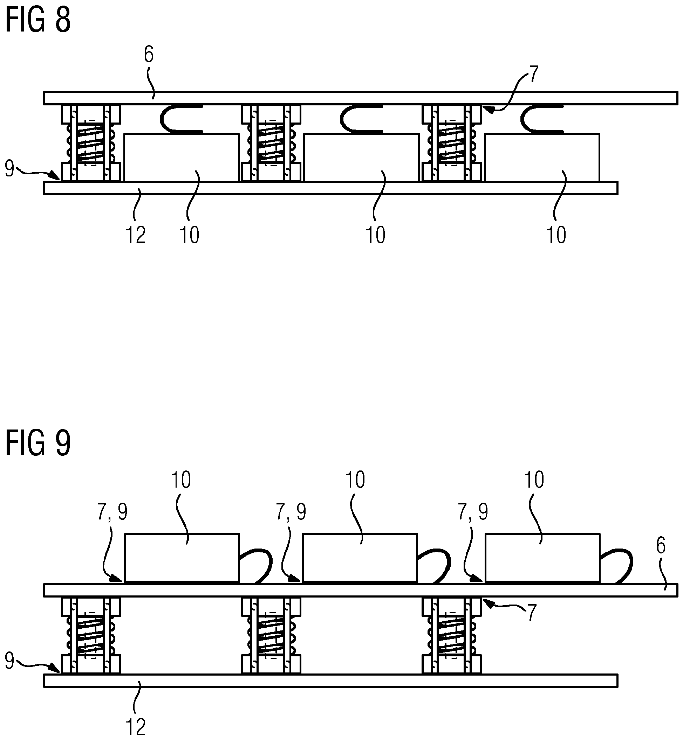

FIG 8 zeigt derartige Anordnungen beispielsweise innerhalb eines Schaltschrankes, wo mehrere Halbleitermodule 10 elektrisch kontaktiert zur Stromschiene 6 angeordnet sind und wo zusätzlich die Stromschiene 6 durch die oben beschriebene Anordnung zusätzlich gekühlt ist.

Die Halbleitermodule 10 sind vorteilhafterweise ebenso wärmeleitend unter Berücksichtigung der Isolationsanforderungen an einer Wärmesenke 12 angeordnet.

Die Halbleitermodule 10 können ebenso direkt wärmeleitend, unter Berücksichtigung der Isolationsanforderungen an der Stromschiene 6 gemäß FIG 9 angeordnet sein.

Erfindungsgemäß können auch mehrere Wärmeaufnahmeelemente 1 auf ein Wärmeabgabeelement 3 geführt werden. Beispielsweise eine dreiphasige Stromschienenanordnung mit jeweils einem oder mehreren Wärmeaufnahmeelementen 1 führen ihre Wärme auf ein Wärmeabgabeelement 3, insbesondere außerhalb eines Schaltschrankes.

Die Vorrichtung zur Kühlung einer Stromschiene 6 eignet sich insbesondere für abgeschlossene beengte räumliche Verhältnisse, in denen vor allem leistungselektronische Geräte, beispielsweise Umrichter vergleichsweise hoher Leistung in Schaltschränken vorgesehen sind.

Ebenso eignet sich die Vorrichtung zur Kühlung einer Stromschiene auch für Schaltanlagen bei besonders beengten räumlichen Verhältnissen, aus denen die Wärmeabzuführen ist. Dies können Schaltanlagen auf Nieder und Mittelspannungsebenen sein.

## Patentansprüche

1. Vorrichtung zur Kühlung einer Stromschiene (6) mit:
- zumindest einem Wärmeaufnahmeelement (1),
- zumindest einem Wärmetransportsystem (2),
- zumindest einem Wärmeabgabeelement (3),
wobei das Wärmeaufnahmeelement (1) formschlüssig an einer Stromschiene (6) anliegt und das Wärmeabgabeelement (3) formschlüssig an einer Wärmesenke (12) anliegt,
wobei das Wärmeaufnahmeelement (1) und das Wärmeabgabeelement (3) parallel zueinander ausgerichtet sind und
wobei zwischen dem Wärmeaufnahmeelement (1) und dem Wärmeabgabeelement (3) angeordnete Druckfedern (4) oder Anpresselemente einen zusätzlichen Anpressdruck schaffen,
wobei das Wärmeaufnahmeelement (1) über das Wärmetransportsystem (2) mit dem Wärmeabgabeelement (3) thermisch leitend verbunden ist.

2. Vorrichtung zur Kühlung einer Stromschiene (6) nach Anspruch 1, **dadurch gekennzeichnet, dass** das Wärmeaufnahmeelement (1) und das Wärmeabgabeelement (3) mittels Wärmeübergabemedien, insbesondere Wärmeleitpasten mit den jeweiligen Wärmequellen bzw. Wärmesenken (12) verbunden sind.

3. Vorrichtung zur Kühlung einer Stromschiene (6) nach Anspruch 1 oder 2, **dadurch gekennzeich-** n e t, dass zumindest das Wärmeaufnahmeelement (1) mittels einer wärmeleitfähigen Isolation (7) mit der Stromschiene (6) kontaktiert ist.

4. Verwendung einer Vorrichtung zur Kühlung zumindest einer Stromschiene (6) nach einem der Ansprüche 1 bis 3 in kompakten elektrischen Schaltanlagen mit Stromschienenanordnungen, insbesondere Schaltschränken von Umrichtern, Niederspannungsschaltanlagen und Mittelspannungsschaltanlagen.

## Claims

1. Device for cooling a bus bar (6) with:
- at least one heat absorption element (1),
- at least one heat transportation system (2),
- at least one heat output element (3),
wherein the heat absorption element (1) rests in a form-fit manner on a bus bar (6) and the heat output element (3) rests in a form-fit manner on a heat sink (12),
wherein the heat absorption element (1) and the heat output element (3) are aligned parallel to one another and
wherein compression springs (4) or contact elements arranged between the heat absorption element (1) and the heat output element (3) produce an additional contact force,
wherein the heat absorption element (1) is connected in a thermally conducting manner to the heat output element (3) by way of the heat transportation system (2).

2. Device for cooling a bus bar (6) according to claim 1, **characterised in that** the heat absorption element (1) and the heat output element (3) are connected to the respective heat sources or heat sinks (12) by means of heat transfer media, in particular heat-conducting pastes.

3. Device for cooling a bus bar (6) according to claim 1 or 2, **characterised in that** at least the heat absorption element (1) makes contact with the bus bar (6) by means of a thermally-conductive insulation (7).

4. Use of a device for cooling at least one bus bar (6) according to one of claims 1 to 3 in compact electrical switching systems with bus bar arrangements, in particular control cabinets of converters, low voltage switching systems and medium voltage switching systems.

## Revendications

1. Dispositif de refroidissement d'un rail (6) d'alimentation en courant comprenant :
- au moins un élément (1) d'absorption de la chaleur,
- au moins un système (2) de transport de la chaleur,
- au moins un élément (3) cédant de la chaleur,
dans lequel l'élément (1) d'absorption de la chaleur s'applique à complémentarité de forme à un rail (6) d'alimentation en courant et l'élément (3) cédant de la chaleur s'applique à complémentarité de forme à un puits (12) de chaleur,
dans lequel l'élément (1) d'absorption de la chaleur et l'élément (3) cédant de la chaleur sont orientés parallèlement l'un à l'autre et
dans lequel des ressorts (4) de compression ou des éléments d'application d'une pression, montés entre l'élément (1) d'absorption de la chaleur et l'élément (3) cédant de la chaleur ou un élément d'application d'une pression, donnent une pression d'application supplémentaire,
dans lequel l'élément (1) d'absorption de la chaleur est relié d'une manière conductrice thermiquement à l'élément (3) cédant de la chaleur par le système (2) de transport de la chaleur.

2. Dispositif de refroidissement d'un rail (6) d'alimentation en courant suivant la revendication 1, **caractérisé en ce que** l'élément (1) d'absorption de la chaleur et l'élément (3) cédant de la chaleur sont reliés aux sources de chaleur ou aux puits (12) de chaleur respectifs au moyen de milieux de transmission de la chaleur, en particulier, au moyen de pâtes conductrices de la chaleur.

3. Dispositif de refroidissement d'un rail (6) d'alimentation en courant suivant la revendication 1 ou 2, **caracté**- **risé en ce** qu'au moins l'élément (1) d'absorption de la chaleur est en contact avec le rail (6) d'alimentation en courant au moyen d'une isolation (7) conductrice de la chaleur.

4. Utilisation d'un dispositif de refroidissement d'au moins un rail (6) d'alimentation en courant suivant les revendications 1 à 3, dans des installations de distribution électrique compactes, ayant des agencements à rail d'alimentation en courant, en particulier des armoires de distribution de convertisseurs, des installations de distribution à basse tension, et des installations de distribution à moyenne tension.
